# EUROPEAN PATENT APPLICATION

(11) **EP 4 579 909 A1**
(43) Date of publication of application: **02.07.2025**
(21) Application number: 24222620.7
(22) Date of filing: 20.12.2024
(51) Int. Cl.: H01M 50/24, H01M 50/244, H01M 50/262, H01M 50/271, H05K 5/02, H05K 5/03, E05B 83/30, E05C 9/04

(54) **ELECTRONIC EQUIPMENT, BATTERY COMPARTMENT AND CABIN COVER THEREOF**

(30) Priority: 25.12.2023 CN 202311795881
(71) Applicant: ChinaBridge (Shenzen) Medical Technology Co., Ltd., Shenzhen, Guangdong 518102 (CN)
(72) Inventor: LI, Yijiang, Shenzhen Guangdong, 518102 (CN)
(74) Representative: Pfenning, Meinig & Partner mbB

(57) **Abstract**

A hatch cover, comprises a cover body (21) having a first sealing ring (22) disposed about a periphery; a first locking unit is provided with a pair of sliding buckles (23) which are connected to the inner side surface of the cover body in a sliding manner, the sliding buckles are locked with the cabin body of the battery cabin along a first direction when moving away from each other to protrude out of the outer periphery of the cover body, and the sliding buckles move in opposite directions to retract to the inner side of the outer periphery of the cover body and unlock relative to the cabin body of the battery cabin; a second locking unit (25) is provided with a rotary buckle which is rotationally connected to the inner side surface of the cover body, the rotary buckle is locked with the cabin body of the battery cabin along a second direction when rotating to a first position, and the rotary buckle is unlocked relative to the cabin body of the battery cabin when rotating to a second position; and a rotary driving unit (24) is connected with the sliding buckle and the rotary buckle and
is used for driving the first locking unit and the second locking unit to synchronously move to a locking state or an unlocking state;
wherein the first direction and the second direction are arranged at an angle.

## Description

### TECHNICAL FIELD

The application relates to the field of electronic equipment, in particular to electronic equipment, a battery compartment and a compartment cover thereof.

### BACKGROUND

Currently, most electronic devices require power supplied from a battery for normal use, and thus a battery compartment is usually provided inside to mount a disposable or reusable rechargeable battery.

In some of these electronic products, it is often necessary to disassemble the battery, and a removable battery compartment cover is usually provided for easy disassembly and protection. The cabin body and the cabin cover of the battery cabin are generally connected in a buckling manner, a locking manner or a rotating shaft manner.

Taking the snap connection as an example, the movable connection is easy to be lost by a customer when the battery hatch is taken down, and the snap connection part does not have a waterproof function and is easy to enter water. The prior art also has a plurality of locking mechanisms for fixing the battery compartment cover, but the plurality of locking mechanisms are required to be opened one by one in the disassembling process, and the requirements of quick disassembly cannot be met.

In the prior art, a simple rotating shaft structure is adopted to connect and fix the battery hatch cover, so that the battery hatch cover and equipment are not detachable and are not easy to lose after being opened, but the structure requires enough space for the rotating shaft. In some cases, the structure is compact, the appearance requirement cannot be achieved in the case of protruding the surface of the shell, the waterproof sealing structure also needs to be in a front-face laminating mode, and the waterproof sealing structure cannot be achieved for some thin-shell products.

For the buckle of battery hatch cover lock, adopt two sliding parts generally, be equipped with resilient means in the middle, under the external force kneading action, its buckle can realize retracting the function of unblock, but this kind of structure can lead to the long clearance of a slip to appear between buckle and the hatch cover, can not realize waterproof sealing. If the sealing ring is added for sealing, the adhesive tape needs to be tightly attached to the connecting gap to meet the sealing waterproof effect, so that the locking or locking needs to overcome the friction force with enough force, and the quick operation of a user is not facilitated. In addition, when the battery compartment cover is fixed by the single buckle or the buckle in a single direction, the single buckle is easy to break or deform and separate to open the battery compartment cover when the battery compartment cover is subjected to large impact vibration, and the battery is separated.

The above arrangement cannot give consideration to the convenience of disassembly and the reliability of locking between the cabin body and the cabin cover, and in order to ensure the convenience of disassembly, the reliability of locking and the reduction of the protection performance of the battery cabin cover are often caused.

### SUMMARY

The application provides electronic equipment, a battery compartment and a compartment cover thereof, which can improve the reliability and the tightness of the compartment cover to the locking of the battery compartment and ensure the convenience of locking and unlocking.

In a first aspect, the present application provides a hatch comprising:
the periphery of the cover body is provided with a first sealing ring;
the first locking unit is provided with a pair of sliding buckles which are connected to the inner side surface of the cover body in a sliding manner, the sliding buckles are locked with the cabin body of the battery cabin along a first direction when moving away from each other to protrude out of the outer periphery of the cover body, and the sliding buckles are unlocked with the cabin body of the battery cabin when moving back to be within the outer periphery of the cover body in opposite directions;
the second locking unit is provided with a rotary buckle which is rotationally connected to the inner side surface of the cover body, the rotary buckle is locked with the cabin body of the battery cabin along a second direction when rotating to a first position, and the rotary buckle is unlocked relative to the cabin body of the battery cabin when rotating to a second position;
the rotary driving unit is connected with the sliding buckle and the rotary buckle and is used for driving the first locking unit and the second locking unit to synchronously move to a locking state or an unlocking state;
wherein the first direction and the second direction are arranged at an angle.

As one implementation mode of the sliding fastener, one end, close to each other, of the pair of sliding fasteners is provided with a driving groove;
the rotary driving unit comprises a driving handle, and the driving handle penetrates through the inner side of the cover body from the outer side of the cover body and is in rotary sealing connection with the cover body;
the driving handle is provided with driving columns which are symmetrically arranged relative to the rotation center of the driving handle, and the driving columns are arranged in the driving grooves in a one-to-one correspondence manner and are in sliding abutting connection with the inner walls of the driving grooves.

As an implementation manner of the present application, the driving handle is coaxially and fixedly connected with the rotating buckle.

As an implementation manner of the present application, the first locking unit is provided with a first elastic member, and the first elastic member is abutted between the cover body and the sliding buckle, and is used for driving the sliding buckle to move away from each other.

As an implementation manner of the present application, the second locking unit is provided with a second elastic member, and the second elastic member is torsionally connected between the cover body and the rotary buckle, and is used for driving the rotary buckle to rotate to the first position.

As an implementation manner of the application, the battery compartment further comprises a hinge assembly, a first end of the hinge assembly is connected with the inner side face of the cover body, a second end of the hinge assembly is used for being fixed in the compartment body of the battery compartment, and the first end of the hinge assembly can rotate around the second end of the hinge assembly so as to drive the compartment cover to open or be buckled relative to the compartment body of the battery compartment.

As an implementation manner of the present application, a second sealing ring is disposed between the driving handle and the rotating matching surface of the cover body.

As one implementation manner of the application, the outer peripheral surface of the cover body is a guide inclined surface and/or a step surface matched with the cabin body of the battery cabin.

As an implementation manner of the application, the first sealing ring is deviated from the periphery side of the cover body and is alternately provided with a plurality of sealing convex edges, and the sealing convex edges are provided with abutting inclined planes.

In a second aspect, the present application provides a battery compartment, including a compartment body and a compartment cover provided in the foregoing embodiment, where a side wall of the compartment body is provided with a mounting opening that is matched with the compartment cover; the cabin body is internally provided with a clamping groove matched with the sliding buckle in a plugging manner and a clamping table matched with the rotary buckle in a clamping manner.

As an implementation manner of the present application, the first direction and the second direction are perpendicular, and the sliding buckle is arranged along the length direction of the hatch cover;

the clamping grooves are formed in two sides outside the mounting opening, the connecting line directions of the clamping grooves on the two sides coincide with the first direction, the clamping table is arranged on the first inner wall and/or the second inner wall of the cabin body, and the first inner wall and the second inner wall are parallel to each other and perpendicular to the second direction.

In a third aspect, the present application provides an electronic device, and the battery compartment is applied.

Compared with the prior art, the technical scheme provided by the embodiment of the application has the following advantages: the first sealing ring at the periphery of the cover body is matched and sealed with the mounting opening of the battery compartment body, so that the sealing performance of the battery compartment is ensured; the inner side surface of the cover body is provided with a first locking unit and a second locking unit, the cover body is locked relative to the cabin body of the battery cabin along a first direction by means of a pair of sliding buckles of the first locking unit moving away from each other until protruding out of the periphery of the cover body, and the cover body is locked relative to the cabin body of the battery cabin along a second direction by means of rotation buckles of the second locking unit; the rotation of the rotation driving unit is utilized to drive the rotation buckle and the sliding buckle to move, and the locking of the first locking unit and the second locking unit can be synchronously realized only by rotating the rotation driving unit.

The unlocking process is opposite, the rotary driving unit is reversely rotated to reset the rotary driving unit, the rotary driving unit drives the sliding buckle to oppositely move to the position within the periphery of the retracted cover body, the cover body is unlocked along the first direction, and meanwhile, the rotary driving unit is rotated to drive the rotary buckle to reset from the first position to the second position, so that the cover body is unlocked along the second direction; namely, the first locking unit and the second locking unit can be synchronously unlocked by driving the rotary driving unit.

The waterproof sealing of the joint of the cabin cover and the installation opening of the battery cabin body is realized by the first sealing ring at the periphery of the cover body; the first locking unit and the second locking unit are utilized to realize a plurality of locking points along a first direction and a second direction relative to the hatch cover of the battery compartment, so that the locking reliability is improved, even if the battery compartment is subjected to larger impact vibration, the locking points are not separated, the cover body is further caused to fall off, and the waterproof sealing performance of the first sealing ring is effectively ensured; and the rotary driving unit can drive the first locking unit and the second locking unit to synchronously lock and unlock, so that the convenience of locking and unlocking is improved.

### BRIEF DESCRIPTION OF THE DRAWINGS

The accompanying drawings, which are incorporated in and constitute a part of this specification, illustrate embodiments consistent with the application and together with the description, serve to explain the principles of the application.

In order to more clearly illustrate the embodiments of the present application or the technical solutions in the prior art, the drawings that are required to be used in the description of the embodiments or the prior art will be briefly described below, and it will be obvious to those skilled in the art that other drawings can be obtained from these drawings without inventive effort.

One or more embodiments are illustrated by way of example and not limitation in the figures of the accompanying drawings, in which like references indicate similar elements, and in which the figures of the drawings are not to be taken in a limiting sense, unless otherwise indicated.
Fig. 1 is a schematic view of a battery compartment provided in an embodiment of the present application in a fully closed state of a lid;
FIG. 2 is a schematic view of the battery compartment of FIG. 1 with the cover open relative to the compartment;
FIG. 3 is a schematic view showing the battery compartment of FIG. 1 with the cover and the compartment separated;
FIG. 4 is a front view of the battery compartment of FIG. 1 along the outside of the cover;
FIG. 5 is a cross-sectional view A-A of FIG. 4;
FIG. 6 is a sectional view B-B of FIG. 4;
FIG. 7 is an enlarged view of section I of FIG. 5;
FIG. 8 is an enlarged view of section II of FIG. 6;
FIG. 9 is an enlarged view of portion III of FIG. 8;
FIG. 10 is an exploded view of the hatch cover of the battery compartment of FIG. 1;
FIG. 11 is a top view of the hatch of FIG. 1;
FIG. 12 is a schematic view of the sliding buckle of FIG. 10;
FIG. 13 is a front view of the drive handle of FIG. 10 in the medial direction;
FIG. 14 is a schematic view of the first seal ring of FIG. 10;
FIG. 15 is a cross-sectional view of C-C of FIG. 11;
Fig. 16 is an enlarged view of the portion iv of Fig. 15.

### DETAILED DESCRIPTION

For the purposes of making the objects, technical solutions and advantages of the embodiments of the present application more clear, the technical solutions of the embodiments of the present application will be clearly and completely described below with reference to the drawings in the embodiments of the present application, and it is apparent that the described embodiments are some embodiments of the present application, but not all embodiments. All other embodiments, which can be made by one of ordinary skill in the art without undue burden from the present disclosure, are within the scope of the present application based on the embodiments herein.

The following disclosure provides many different embodiments, or examples, for implementing different structures of the application. In order to simplify the disclosure of the present application, the components and arrangements of specific examples are described below. Of course, they are merely examples and are not intended to limit the present application. Furthermore, the present application may repeat reference numerals and/or letters in the various examples. This repetition is for the purpose of simplicity and clarity and does not in itself dictate a relationship between the various embodiments and/or configurations discussed.

For ease of description, spatially relative terms, such as "inner," "outer," "lower," "upper," "above," "front," "rear," and the like, may be used herein to describe one element's or feature's relative positional relationship or movement to another element's or feature as illustrated in the figures. Such spatially relative terms are intended to encompass different orientations of the device in use or operation in addition to the orientation depicted in the figures. For example, if the device in the figure experiences a position flip or a change in attitude or a change in state of motion, then the indications of these directivities correspondingly change, for example: an element described as "under" or "beneath" another element or feature would then be oriented "over" or "above" the other element or feature. Thus, the example term "below ......" may include both upper and lower orientations. The device may be otherwise oriented (rotated 90 degrees or in other directions) and the spatial relative relationship descriptors used herein interpreted accordingly.

In order to solve the technical problem that the protection performance of the hatch cover 200 of the battery compartment in the prior art is insufficient, the application provides electronic equipment, the battery compartment and the hatch cover 200 thereof, the reliability and the sealing performance of locking between the hatch body 100 and the hatch cover 200 of the battery compartment can be improved, and the locking and unlocking of the hatch cover 200 relative to the hatch body 100 are very convenient.

It should be noted that, in the following description, the inner side surface of the cover 21 refers to the end surface of the cover 21 facing the inner periphery of the cabin 100, and the outer side surface of the cover 21 refers to the end surface of the cover 21 that is substantially flush with the outer surface of the cabin 100 after being sealed and locked with respect to the cabin 100.

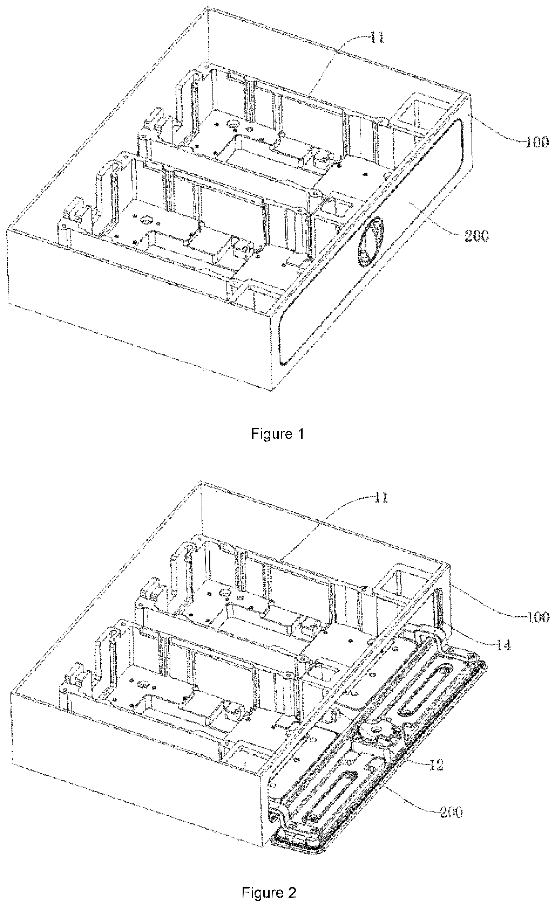

Referring to Fig. 1 to 3 and 10, the present embodiment provides a hatch 200, which is suitable for sealing a hatch body 100 of a battery compartment of an electronic device to improve dust-proof and water-proof performance. The battery compartment mainly comprises a compartment body 100 and a compartment cover 200, wherein the compartment body 100 is provided with a mounting opening 14, a battery can be replaced from the mounting opening 14, and the compartment cover 200 is mainly used for sealing the mounting opening 14. In order to ensure the reliability and the tightness of the hatch 200 to lock at the mounting opening 14 of the hatch 100, the hatch 200 mainly includes a cover body 21, a first locking unit, a second locking unit, and a rotation driving unit. The shape of the cover 21 is adapted to the shape of the mounting opening 14 of the cabin 100, which is rectangular with rounded corners in the drawing, and can be set to a suitable shape as required. The first seal ring 22 is provided on the outer periphery or outer peripheral surface of the cover 21, and the outer peripheral surface of the cover 21 refers to a side surface or thickness surface that is in contact with the inner periphery of the mounting opening 14 when the cover 21 is mounted in the mounting opening 14 of the cabin 100.

The first locking unit includes a pair of slide catches 23, and the pair of slide catches 23 are slidably connected to the inner side surface of the cover 21 and are capable of moving relative to each other or away from each other when driven. The pair of sliding buckles 23 are arranged along the first direction, and when the pair of sliding buckles 23 move away from each other and enable the ends of the sliding buckles 23 away from each other to protrude out of the periphery of the cover body 21, the ends of the sliding buckles 23 away from each other are blocked on the inner wall of the periphery of the mounting opening 14 of the cabin 100, so that the cover body 21 is locked relative to the cabin cover 200 along the first direction. Correspondingly, when the pair of sliding buckles 23 move towards each other to enable the ends of the sliding buckles, which are away from each other, to retract to the inside of the outer periphery of the cover body 21, the ends of the locking buckles, which are away from each other, are disengaged from the inner wall of the periphery of the mounting opening 14 of the cabin 100, so that the cover body 21 is unlocked relative to the cabin cover 200 along the first direction.

The second locking unit comprises a rotary buckle 25, wherein the rotary buckle 25 is rotatably connected to the inner side surface of the cover body 21 and can rotate between a first position and a second position relative to the inner side surface of the cover body 21, and the rotary buckle 25 at the first position and the rotary buckle 25 at the second position form a preset included angle. When the cover 21 is mounted to the mounting opening 14 of the battery compartment 100, the rotary buckle 25 rotates from the second position to the first position to lock with the battery compartment 100 along the second direction; when the rotary latch 25 is rotated from the first position to the second position, the rotary latch 25 is unlocked in the second direction with respect to the body 100 of the battery compartment.

The rotation driving unit is connected with the sliding buckle 23 of the first locking unit and the rotation buckle 25 of the second locking unit, and can drive the first locking unit and the second locking unit to synchronously move to a locking state or an unlocking state.

The third position and the fourth position where the rotation driving unit has rotation switching will be described, and when the rotation driving unit is in the third position, the pair of slide latches 23 are kept in a locked state in which the ends of the slide latches that are far away from each other protrude from the outer periphery of the cover 21, and the rotation latches 25 are correspondingly in the first position. When the rotation driving unit rotates from the third position to the fourth position, the pair of sliding buckles 23 are driven to move close to each other, and one ends of the pair of sliding buckles 23, which are away from each other, move and retract to the inside of the periphery of the cover body 21, namely, the sliding buckles 23 are driven to move to an unlocking state; meanwhile, the rotary buckle 25 rotates from the first position to the second position corresponding to the unlocking state, so that the first locking unit and the second locking unit are driven to unlock synchronously.

When the rotary driving unit is rotated from the fourth position to the third position, the pair of sliding buckles 23 are driven to move away from each other, so that one ends of the pair of sliding buckles 23 away from each other protrude out of the periphery of the cover body 21 to be switched to a locking state; meanwhile, the rotary buckle 25 is driven to rotate from the second position to reset to the first position corresponding to the locking state, so that the first locking unit and the second locking unit are driven to be locked synchronously.

In particular, the first direction and the second direction are set at a certain angle, so as to realize uniform alternate fixation of multiple points on the periphery of the cover 21 relative to the mounting opening 14 of the cabin 100, improve the locking reliability of the cover 21 relative to the cabin 100, and even if the cover is subjected to larger impact vibration, the locking points are not separated, so that the cover 21 is separated, the tightness of the cover 21 and the cabin 100 is improved, and the protection capability of the cabin cover 200 is optimized. And the provision of the rotation driving unit to drive the first locking unit and the second locking unit to move synchronously to the locked state or the unlocked state improves the convenience of locking and unlocking the cover 21 with respect to the deck 100. The first direction, the second direction and the arrangement of the included angle between the first direction and the second direction can be adjusted according to the requirement.

The essence of the above-mentioned rotation driving unit driving the first locking unit and the second locking unit to move synchronously to the locked or unlocked state is that: the rotation driving unit is capable of transmitting rotation of itself to the rotation buckle 25 to drive the rotation buckle 25 to rotate, and simultaneously converting rotation of itself into linear reciprocating motion of the pair of sliding buckles 23 through a transmission connection structure with the sliding buckle 23, and a structure of the rotation driving unit driving the first locking unit and the second locking unit will be described with reference to specific embodiments.

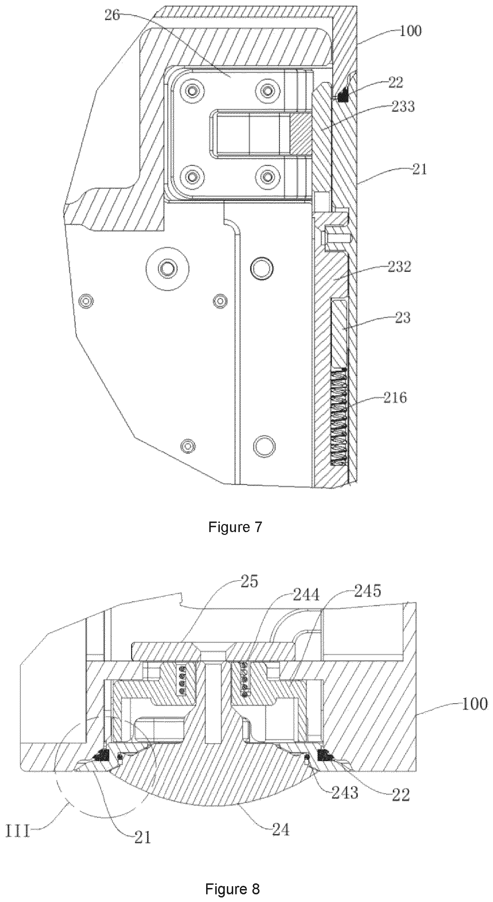

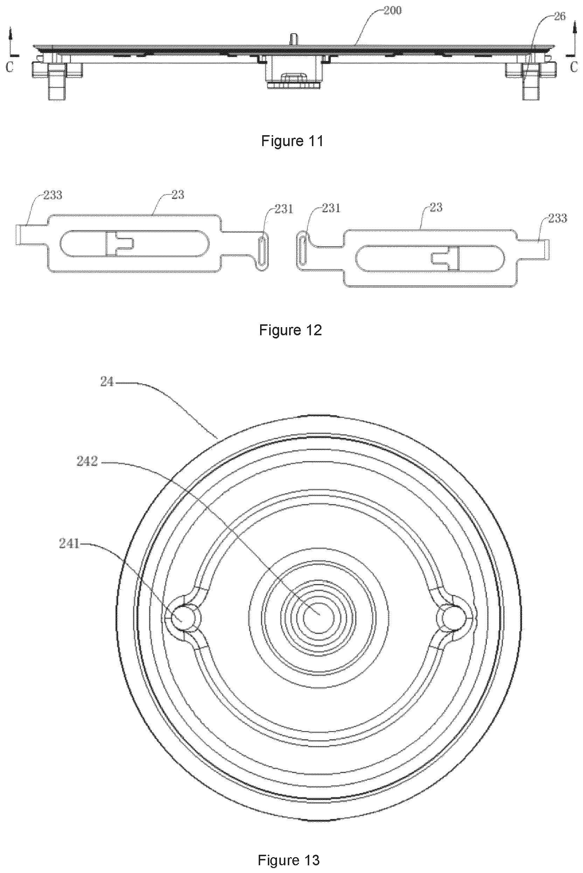

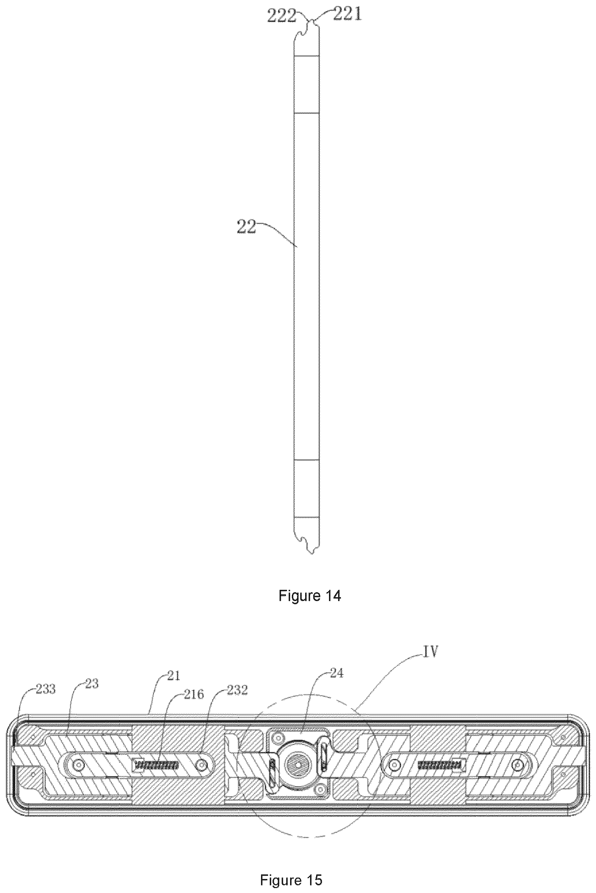

Referring to Fig. 7 to 13 and 15, in the present embodiment, the cover 21 has a rectangular plate structure with rounded corners, the first direction is the longitudinal direction of the cover 21, i.e. the left-right direction shown in Fig. 15, and the second direction is the width direction of the cover 21, i.e. the up-down direction or the height direction shown in Fig. 15. The inner side surface of the cover 21 is provided with a limiting chute 215 extending along the length direction thereof, and a pair of sliding buckles 23 are respectively arranged in the limiting chute 215 in a sliding manner. One end, close to each other, of the pair of sliding buckles 23 serves as a driving end of the sliding buckle 23, and the driving end of each sliding buckle 23 is provided with a driving groove 231; the rotation driving unit includes a driving handle 24, the driving handle 24 extends from the outer side surface of the cover 21 to the inner side surface of the cover 21, a pair of driving posts 241 are protruded toward the inner side direction of the cover 21 from one side of the driving handle 24 extending to the inner side surface of the cover 21, and the pair of driving posts 241 are preferably symmetrically arranged about the rotation axis of the driving handle 24. The pair of driving posts 241 are respectively disposed in the driving grooves 231 of the pair of sliding buckles 23, and the driving posts 241 are in sliding contact with the inner walls of the driving grooves 231. The driving handle 24 is in rotary sealing connection with the cover body 21, so that the sealing performance of the driving handle 24 penetrating through the cover body 21 is ensured.

When the driving handle 24 is rotated from the outside of the cover 21, the driving handle 24 rotates to drive the driving post 241 to rotate, the driving post 241 generates a displacement component in a first direction or the length direction of the cover 21, and the driving post 241 drives the pair of sliding buckles 23 to move towards each other or away from each other while sliding along the inner wall of the driving groove 231. In the illustrated embodiment, the extending direction of the driving groove 231 is set to be the same as the width direction of the cover 21; in a specific implementation, the driving groove 231 may be disposed at a certain angle with respect to the width direction of the cover 21. The driving groove 231 preferably adopts a kidney-shaped hole groove structure, and the width of the driving groove 231 is set to be equal to or slightly larger than the diameter of the driving post 241.

The driving handle 24 penetrates to one surface of the inner side of the cover body 21 and is provided with an axle center column 242, the rotary buckle 25 is fixedly connected with the axle center column 242 in a coaxial way, the rotary buckle 25 is provided with a notch part along the circumferential direction, so that when the cover body 21 is buckled and sealed on the cover body 100 through the notch part corresponding to a stop structure in the cover body 100, the stop structure in the cover body 100 enters between the rotary buckle 25 and the inner side wall surface of the cover body 21 through the notch part of the rotary buckle 25, and when the rotary buckle 25 rotates to the stop structure in the cover body 100 with the wall surface facing the cover body 21 in abutting connection, the locking of the cover body 100 along the second direction is realized.

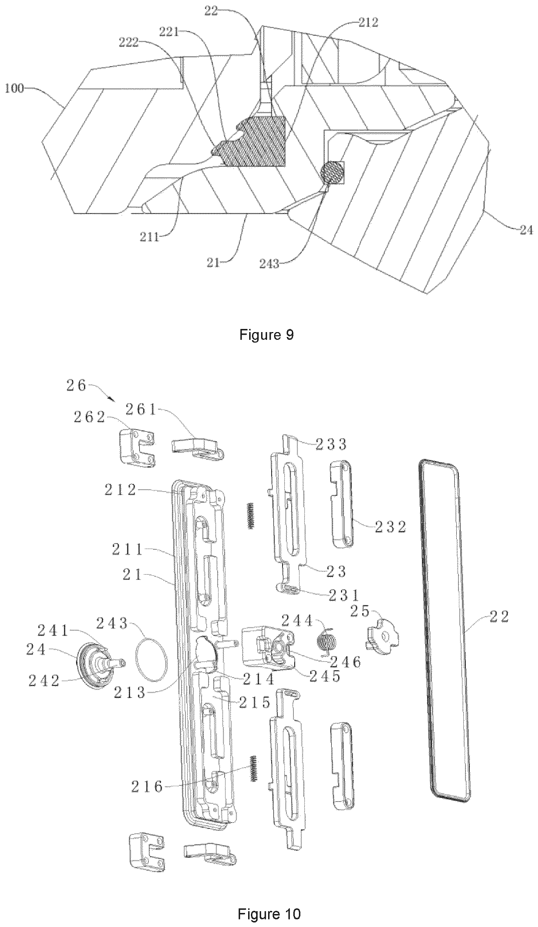

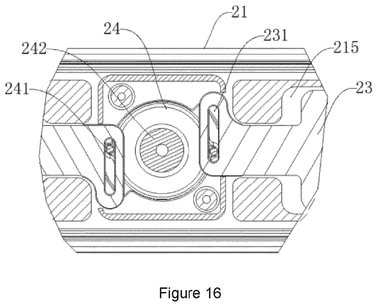

Referring to Fig. 10, 12, 15 and 16, one end of the sliding buckle 23 facing away from each other is a locking end 233, the locking end 233 is configured as a latch structure and is used for being matched with clamping grooves on two sides of the inner wall of the cabin 100 in the first direction of the mounting opening 14, so that the locking end 233 can conveniently enter the clamping grooves on the inner wall of the cabin 100, and the tail end of the locking end 233 is configured as an inclined surface shape, so that the thickness of the locking end 233 gradually increases from the locking end 233 to the driving end.

In some embodiments, to ensure the sliding connection between the sliding buckle 23 and the cover 21, the sliding buckle 23 is prevented from being separated from the limiting chute 215 on the inner side surface of the cover 21, and the first locking unit further includes a limiting bead 232 for pressing the sliding buckle 23 to limit the sliding buckle within the limiting chute 215. The sliding buckle 23 is provided with a sliding positioning groove along the length direction, and a group of limiting baffle plates are connected between groove walls on two sides of the sliding positioning groove. The limiting chute 215 is internally provided with a sinking groove, the sinking groove is internally provided with a connecting column, and the connecting column does not interfere the sliding of the sliding buckle 23 in the limiting chute 215. The limit pressing strip 232 is fixedly connected with the cover body 21 through a connecting column. The limiting pressing strip 232 is of a groove shell structure reversely buckled on the cover body 21, and the limiting baffle of the sliding buckle 23 is limited by the limiting pressing strip 232 and can only slide in the range covered by the limiting pressing strip 232. The limiting pressing strips 232 press the sliding buckle 23 into the limiting sliding groove 215 while limiting the sliding stroke of the sliding buckle 23, so that the sliding buckle 23 is prevented from being separated from the limiting sliding groove 215, and the locking and butting precision of the sliding buckle 23 and the cabin 100 is improved.

Further, the first locking unit further comprises a first elastic member 216, and the first elastic member 216 is pressed and abutted between the cover 21 and the sliding buckle 23, so as to drive the sliding buckle 23 to move away from each other. Specifically, one end of the first elastic member 216 abuts against one end of the limiting bead 232 near the driving end, and the other end abuts against the limiting stop of the sliding buckle 23. Because the end of the limiting blocking piece, which is abutted by the first elastic piece 216, is close to two sides of the cover 21 in the length direction than the limiting pressing strip 232, the limiting pressing strip 232 is fixedly connected with the cover 21 through the connecting column, and the first elastic piece 216 is in a precompressed state, the sliding buckle 23 slides to two sides of the cover 21 in the length direction under the elastic force of the first elastic piece 216, and therefore the first elastic piece 216 drives the pair of sliding buckles 23 to deviate from each other.

In some embodiments, the second locking unit includes a second elastic member 244, and the second elastic member 244 employs a torsion spring torsionally connected between the cover 21 and the rotation buckle 25, and drives the rotation buckle 25 to rotate back to the first position by an elastic force generated by the torsion of the torsion spring, so as to maintain the rotation buckle 25 in a locked state.

The first elastic member 216 is provided to hold the slide fastener 23 in a locked state with respect to the battery compartment body 100 in the first direction; the second elastic member 244 is provided to hold the rotary latch 25 in a locked state in the second direction with respect to the battery compartment body 100; that is, the reliability of locking the cover 21 with respect to the pod 100 can be further ensured by the provision of the first elastic member 216 and the second elastic member 244.

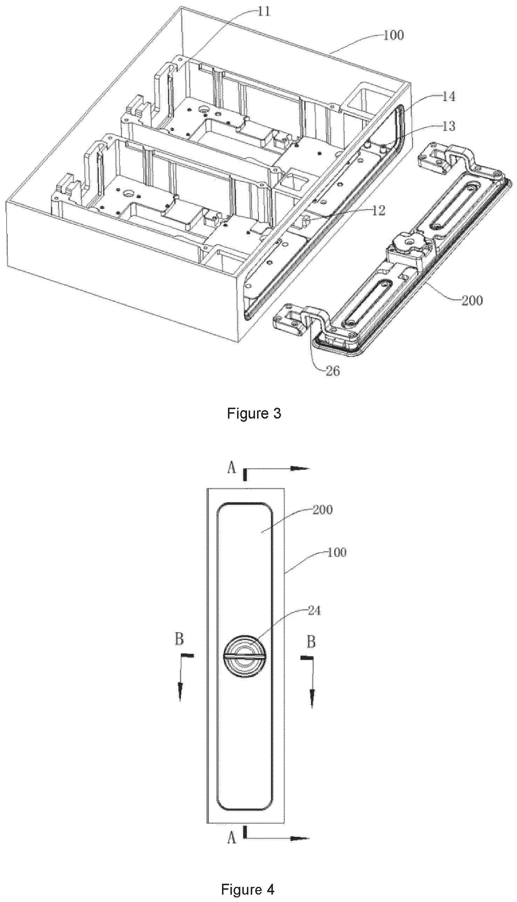

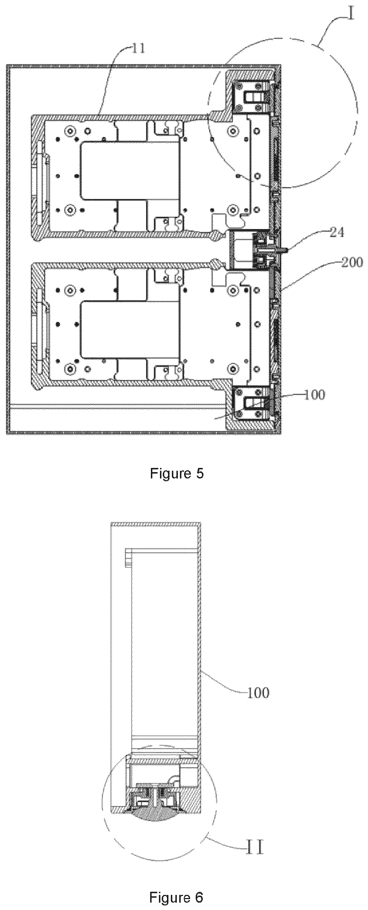

Referring to Fig. 4, Fig. 6, Fig. 8, and Fig. 10 in combination, the hatch 200 provided in the embodiment of the application further includes a limiting shell 245, where the limiting shell 245 is a shell-like structure disposed towards the inner side surface of the cover 21. The limit housing 245 covers the outer periphery of the inner side surface of the cover 21 of the driving handle 24. Two sides of the limiting shell 245 along the first direction are provided with notches for extending the sliding buckles 23; the size of the notch is smaller than that of the driving end, so that the driving end of the sliding buckle 23 is limited in the limiting shell 245, the sliding buckle 23 is limited, and the length of the outer peripheral part of the cover body 21, from which one ends of the sliding buckle 23 deviate from each other, is limited.

The axle center of the limit shell 245 is provided with an axle hole for the rotary buckle 25 and the driving handle 24 to pass through so as to realize coaxial and fixedly connection. One side of the limiting shell 245, which is away from the cover body 21, is provided with an annular groove, the annular groove is located at the periphery of the shaft hole, the second elastic piece 244 adopts a torsion spring, the torsion spring is accommodated in the annular groove, one group of torsion arms of the torsion spring are connected with the limiting shell 245, and the other group of torsion arms are connected with the rotary buckle 25.

The surface of the side, facing away from the cover 21, of the limiting shell 245 is further provided with a limiting groove 246 concavely arranged towards the direction of the cover 21, and when the rotary buckle 25 is at the first position, the buckle structure at the periphery of the rotary buckle 25 seals the limiting groove 246. When the rotary buckle 25 is at the second position, the notch part at the periphery corresponds to the limit groove 246, and when the cover body 21 is buckled and sealed on the mounting opening 14 of the cabin 100, the stop structure in the cabin 100 enters the limit groove 246 of the limit shell 245 through the notch part of the rotary buckle 25; when the rotary buckle 25 is reset from the second position to the first position, the limiting groove 246 of the limiting shell 245 is closed again, namely, the rotary buckle and the stop structure in the cabin 100 form mutual locking, so that the locking of the rotary buckle relative to the cabin 100 along the second direction is realized.

In order to improve the connection seal between the hatch 200 and the hatch 100, and to avoid the loss of the hatch 200, the hatch 200 provided in the embodiments of the application is further provided with a hinge assembly 26, so that the hatch 200 is turned over and opened relative to the hatch 100 by the hinge assembly 26.

Referring to Fig. 2, 3 and 10 together, the first end of the hinge assembly 26 is adapted to be coupled to the inner side of the cover 21; the second end of the hinge assembly 26 is fixedly connected to the hinge fixing seat 13 in the cabin 100, and the first end of the hinge assembly 26 can rotate around the second end, that is, the rotation center of the hinge assembly 26 is located at the second end or in the cabin 100, so that the cover 21 can be completely buckled with the installation opening 14 of the cabin 100. Specifically, the hinge assembly 26 includes a first hinge member 261 at a first end and a second hinge member 262 at a second end. The second hinge member 262 has a seat-shaped structure and can be fixedly connected with the hinge fixing seat 13 in the cabin 100, one end of the first hinge member 261 is attached to the inner side surface of the cover 21, and the second end is protruded in a direction away from the cover 21, so that the rotation center of the hinge assembly 26 is transferred to the second end or the interior of the cabin 100.

In some embodiments, to ensure a connection seal between the drive handle 24 and the cover 21, a second seal 243 is provided between the rotary mating surfaces of the drive handle 24 and the cover 21, and the seal performance of the drive handle 24 penetrating the cover 21 is improved by the second seal 243.

Referring to Fig. 4, 6 and 8 to 10, the cover 21 is provided with a rotation positioning hole 213, and the driving handle 24 passes through the rotation positioning hole 213 and is fixedly connected with the rotation buckle 25. The periphery of the rotary positioning hole 213 is symmetrically provided with a fan-shaped limiting hole 214, the limiting hole 214 is communicated with the rotary positioning hole 213, the driving column 241 penetrates into the inner side surface of the cover body 21 from the limiting hole 214, and the limiting hole 214 plays a limiting role on the rotation of the driving column 241 and the driving handle 24. When the driving post 241 rotates from the first end to the second end of the limiting hole 214, the driving slot 231 drives the sliding buckle 23 to move from the locking state away from each other to the unlocking state close to each other, and simultaneously drives the rotating buckle 25 to rotate from the first position to the second position.

The radial dimension of the rotary positioning hole 213 from the outer side surface of the cover body 21 to the inner side surface of the cover body 21 changes, the whole body shows a gradually shrinking trend, and the radial dimension of the driving handle 24 is matched with the rotary positioning hole 213. The matching surfaces of the two are alternately arranged by adopting an inclined surface and a step surface, and a second sealing ring 243 is arranged between the driving handle 24 and the step surface of the rotary positioning hole 213. The annular inwardly protruding ribs and the annular grooves can be arranged between the step surfaces of the two according to the requirement, so that the rotation tightness between the driving handle 24 and the rotation positioning hole 213 is improved.

The arrangement of the outer peripheral surface of the cover 21 and the mating seal structure of the cover 21 and the mounting opening 14 of the cabin 100 can refer to the rotation positioning hole 213 and the driving handle 24. In general, the outer peripheral surface of the cover 21 and the mounting opening 14 may be sealed by a slant fit, or may be sealed by a stepped surface 212.

Referring to Fig. 4, 5, 7 to 9 and 14, in a preferred embodiment provided herein, the outer peripheral surface of the cover 21 is provided in a combination of a guide inclined surface 211 and a stepped surface 212, the guide inclined surface 211 is disposed near the outer side surface of the cover 21, the stepped surface 212 is connected to one side of the guide inclined surface 211 near the inner side surface of the cover 21, and the first sealing ring 22 is sleeved on the outer periphery of a set of stepped surfaces 212 of the cover 21. The guiding inclined plane 211 plays a role in connection and sealing on one hand, and plays a role in avoiding and guiding to a certain extent when the cover body 21 is turned over and buckled at the installation opening 14 of the cabin 100, so that the cover body 21 is conveniently buckled at the installation opening 14 of the cabin 100.

In order to improve the matching degree between the first sealing ring 22 and the inner circumferential surface of the installation opening 14 of the cabin body 100, a plurality of rings of sealing convex edges 221 are arranged on the outer circumferential side of the first sealing ring 22, the sealing convex edges 221 can generate certain deformation, and the connection sealing between the first sealing ring and the installation opening 14 is improved by abutting the inner circumferential surface of the installation opening 14 after interference fit and bending deformation with the inner circumferential surface of the installation opening 14. The inner periphery of the mounting opening 14 is provided with an inclined surface corresponding to the position of the first sealing ring 22, and the tail end of the sealing convex edge 221 is provided with an abutting inclined surface 222, and is matched with the inclined surface of the inner periphery of the mounting opening 14, so that the sealing of the joint is improved.

The embodiment of the application further provides a battery compartment, as shown in Fig. 1 to 3, including a compartment body 100 and a compartment cover 200 provided in the foregoing embodiment, where a mounting opening 14 is formed in a side wall of the compartment body 100, and the mounting opening 14 is a rectangular opening matched with the cover body 21. The inner arm of the cabin 100 is provided with a clamping groove in plug-in fit with the sliding buckle 23, a clamping table 12 in clamping fit with the rotating buckle 25, and a hinge fixing seat 13 for fixing the hinge assembly 26.

In this embodiment, the first direction is perpendicular to the second direction, the first direction is the length direction of the cover 21 and the mounting opening 14, and the clamping grooves are located at two outer sides of the length direction of the mounting opening 14 in the cabin 100, that is, the connecting line direction of the pair of clamping grooves coincides with the first direction or the length direction of the mounting opening 14. The clamping tables 12 are arranged on at least one of the first inner wall and the second inner wall in the cabin 100, and the arrangement of the notch parts of the rotary buckles 25 and the arrangement of the limit grooves 246 of the limit shells 245 correspond to the number of the clamping tables 12 in the cabin 100. The first inner wall and the second inner wall are a bottom plate and a top plate (not shown in the drawings) of the cabin 100 in Fig. 1 to 3, and the top plate and the bottom plate are disposed substantially parallel to each other and perpendicular to the height direction or the second direction of the cabin 100.

The hinge fixing base 13 is usually provided at the bottom plate of the cabin 100, that is, the cover 21 is in a flip-down open form. It is of course also possible to arrange the hinge assembly 26 and the hinge fixing base 13 between the top of the cover 21 and the ceiling of the cabin 100, respectively, so that the cover 21 takes the form of being turned upside down. The battery compartment seat 11 for fixing the battery is arranged in the compartment body 100, and the battery in the battery compartment seat 11 can be replaced through the installation opening 14 after the compartment cover 200 is opened.

The embodiment of the application also provides electronic equipment, and the battery compartment provided by the embodiment is applied.

It is to be understood that the terminology used herein is for the purpose of describing particular example embodiments only, and is not intended to be limiting. As used herein, the singular forms "a", "an" and "the" are intended to include the plural forms as well, unless the context clearly indicates otherwise. The terms "comprises," "comprising," "includes," "including," and "having" are inclusive and therefore specify the presence of stated features, steps, operations, elements, and/or components, but do not preclude the presence or addition of one or more other features, steps, operations, elements, components, and/or groups thereof. The method steps, processes, and operations described herein are not to be construed as necessarily requiring their performance in the particular order described or illustrated, unless an order of performance is explicitly stated. It should also be appreciated that additional or alternative steps may be used.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

The foregoing is merely a specific embodiment of the application to enable one skilled in the art to understand or practice the application. Various modifications to these embodiments will be readily apparent to those skilled in the art, and the generic principles defined herein may be applied to other embodiments without departing from the spirit or scope of the application. Thus, the present application is not intended to be limited to the embodiments shown herein but is to be accorded the widest scope consistent with the principles and novel features disclosed herein.

## Claims

1. A hatch cover, comprising:
a cover body having a first sealing ring disposed about a periphery;
a first locking unit is provided with a pair of sliding buckles which are connected to the inner side surface of the cover body in a sliding manner, the sliding buckles are locked with the cabin body of the battery cabin along a first direction when moving away from each other to protrude out of the outer periphery of the cover body, and the sliding buckles move in opposite directions to retract to the inner side of the outer periphery of the cover body and unlock relative to the cabin body of the battery cabin;
a second locking unit is provided with a rotary buckle which is rotationally connected to the inner side surface of the cover body, the rotary buckle is locked with the cabin body of the battery cabin along a second direction when rotating to a first position, and the rotary buckle is unlocked relative to the cabin body of the battery cabin when rotating to a second position; and
a rotary driving unit is connected with the sliding buckle and the rotary buckle and is used for driving the first locking unit and the second locking unit to synchronously move to a locking state or an unlocking state;
wherein the first direction and the second direction are arranged at an angle.

2. The hatch cover of claim 1, wherein
a pair of the slide buckles are each provided with a drive slot at one end thereof that is adjacent to each other;
the rotary driving unit comprises a driving handle, and the driving handle penetrates through the inner side of the cover body from the outer side of the cover body and is in rotary sealing connection with the cover body;
the driving handle is provided with driving columns which are symmetrically arranged relative to the rotation center of the driving handle, and the driving columns are arranged in the driving grooves in a one-to-one correspondence manner and are in sliding abutting connection with the inner walls of the driving grooves.

3. The hatch cover of claim 2, wherein the drive handle is fixedly connected coaxially with the swivel catch.

4. The hatch cover of claim 1, **characterized in that** the first locking unit is provided with a first elastic element, which is abutting between the cover body and the sliding catch for driving the sliding catches against each other.

5. The hatch cover of claim 1, **characterized in that** the second locking unit is provided with a second elastic member which is torsionally connected between the cover body and the rotary catch for driving the rotary catch into rotation to a first position.

6. The hatch cover of any of claims 1-5, further comprising a hinge assembly, a first end of the hinge assembly being coupled to an inner side of the cover, a second end of the hinge assembly being adapted to be secured within the body of the battery compartment, the first end of the hinge assembly being rotatable about the second end thereof to facilitate opening or snapping of the hatch cover relative to the body of the battery compartment.

7. The hatch cover of claim 2, wherein a second sealing ring is provided between the driving handle and the rotating mating surface of the cover body.

8. The hatch cover of claim 1, wherein the outer circumferential surface of the cover body is a guiding inclined surface and/or a stepped surface which is matched with the hatch body of the battery compartment.

9. The hatch cover of claim 1, wherein the first sealing ring is provided with a plurality of sealing flanges at intervals on the outer peripheral side facing away from the cover body, and wherein the sealing flanges are provided with abutting inclined surfaces.

10. A battery compartment comprising a compartment body and a compartment cover according to any one of claims 1-9, the side wall of the compartment body being provided with a mounting opening for cooperation with the compartment cover; the cabin body is internally provided with a clamping groove matched with the sliding buckle in a plugging manner and a clamping table matched with the rotary buckle in a clamping manner.

11. The battery compartment of claim 10, wherein:
the first and second directions are perpendicular, the sliding catch being disposed along a length of the hatch;
the clamping grooves are formed in two sides outside the mounting opening, the connecting line directions of the clamping grooves on the two sides coincide with the first direction, the clamping table is arranged on the first inner wall and/or the second inner wall of the cabin body, and the first inner wall and the second inner wall are parallel to each other and perpendicular to the second direction.

12. An electronic device, **characterized in that** the battery compartment of claim 10 or 11 is applied.
